# EUROPÄISCHE PATENTSCHRIFT

(11) **EP 3 423 288 B1**
(45) Veröffentlichungstag und Bekanntmachung des Hinweises auf die Patenterteilung: **13.07.2022**
(21) Anmeldenummer: 17707466.3
(22) Anmeldetag: 22.02.2017
(51) Int. Cl.: B42D 25/425, B42D 25/324, B42D 25/328

(54) **PRÄGEPLATTE, HERSTELLUNGSVERFAHREN UND GEPRÄGTES SICHERHEITSELEMENT**
EMBOSSING PLATE, PRODUCTION METHOD, AND EMBOSSED SECURITY ELEMENT
PLAQUE À GAUFRER, PROCÉDÉ DE FABRICATION ET ÉLÉMENT GAUFRÉ

(30) Priorität: 29.02.2016 DE 102016002451
(43) Veröffentlichungstag der Anmeldung: 09.01.2019
(60) Teilanmeldung: 22020258.4
(73) Patentinhaber: Giesecke+Devrient Currency Technology GmbH, 81677 München (DE)
(72) Erfinder: STÖCKL, Christian, 83703 Gmund a. Tegernsee (DE); RAHM, Michael, 83646 Bad Tölz (DE); AMTHOR, Falk, 83714 Miesbach (DE); LOCHBIHLER, Hans, 80337 München (DE); SCHINABECK, Josef, 82467 Garmisch-Partenkirchen (DE); FUHSE, Christian, 83624 Otterfing (DE); SCHERER, Maik Rudolf Johann, 82491 Grainau (DE); GERSTL, Christine, 83064 Raubling (DE); RAUCH, Andreas, 82441 Ohlstadt (DE)
(74) Vertreter: Giesecke + Devrient IP
(86) Internationale Anmeldenummer: PCT/EP2017/000252
(87) Internationale Veröffentlichungsnummer: WO 2017/148575

(56) Entgegenhaltungen:
- EP-B1- 1 868 822
- DE-A1-102007 061 979

## Beschreibung

Die Erfindung betrifft eine Prägeplatte zum Einprägen eines gewünschten Motivs, das zumindest zwei Teilbereiche mit unterschiedlichem optischem Erscheinungsbild enthält, in ein Prägesubstrat. Die Erfindung betrifft auch ein Verfahren zum Herstellen einer solchen Prägeplatte sowie ein mit einer solchen Prägeplatte herstellbares Sicherheitselement.

Datenträger, wie Wert- oder Ausweisdokumente, aber auch andere Wertgegenstände, wie etwa Markenartikel, werden zur Absicherung oft mit Sicherheitselementen versehen, die eine Überprüfung der Echtheit des Datenträgers gestatten und die zugleich als Schutz vor unerlaubter Reproduktion dienen.

Eine besondere Rolle bei der Echtheitsabsicherung spielen Sicherheitselemente mit betrachtungswinkelabhängigen Effekten, da diese selbst mit modernsten Kopiergeräten nicht reproduziert werden können. Die Sicherheitselemente werden dabei mit optisch variablen Elementen ausgestattet, die dem Betrachter unter unterschiedlichen Betrachtungswinkeln einen unterschiedlichen Bildeindruck vermitteln und beispielsweise je nach Betrachtungswinkel einen anderen Farb- oder Helligkeitseindruck und/ oder ein anderes grafisches Motiv zeigen.

In diesem Zusammenhang ist es bekannt, Datenträger zur Absicherung mit geprägten, optisch wirksamen Sicherheitselementen zu versehen, welche beispielsweise Subwellenlängengitter, holografische Gitter, Mikrospiegelanordnungen oder Mikrolinsenraster enthalten. Die charakteristische Strukturgröße der jeweiligen Prägeelemente, die durch die Gitterperioden bzw. Rasterperioden der jeweiligen Anordnungen gegeben ist, reicht dabei von etwa 200 nm für die Gitterperioden von Subwellenlängengittern bis zu Mikrolinsenrastern oder Mikrospiegelrastern mit einer Rasterweite von 20 µm und mehr.

Subwellenlängengitter, diffraktive Gitter und Mikrolinsenraster bzw. Mikrospiegelraster unterschieden sich jedoch nicht nur in den charakteristischen Strukturgrößen, sondern auch ihrem Erscheinungsbild und den jeweils erzeugten visuellen Effekten. Während Subwellenlängenstrukturen Farben in Reflexion und Transmission erzeugen, wobei der Farbeindruck abhängig von der konkreten verwendeten Geometrie sowohl betrachtungswinkelabhängig als auch beim Kippen farbstabil sein kann, erzeugen die größeren diffraktiven Gitter durch die Beugung und Aufspaltung des Lichts in Spektralfarben stets eine betrachtungswinkelabhängige Farbvariation. Mikrospiegelraster erscheinen wegen der Größe der Mikrospiegel von mehreren Mikrometern achromatisch, zeigen aber dynamische Effekte oder erzeugen trotz einer im Wesentlichen ebenen Gestaltung für den Betrachter dreidimensionale Erscheinungsbilder.

Geprägte Sicherheitselemente weisen in der Regel nur eine der genannten Strukturen auf und zeigen dann bei der Betrachtung entsprechende Effekte. Teilweise sind auch mehrere separate Strukturen verschiedener Größenordnung auf einem Sicherheitselement oder dekorativen Element vorgesehen. Ein Beispiel ist in der Druckschrift US 7 433 105 B2 beschrieben, bei dem auf einem dekorativen Element holografische Strukturen um eine Fresnellinse herum angeordnet sind.

Aus der Druckschrift EP 1 868 822 B1 ist eine Transferfolie bekannt, die eine Trägerfolie und eine auf der Trägerfolie angeordnete und von dieser ablösbare Übertragungslage mit einer Strukturschicht umfasst. Dabei ist vorgesehen, dass die Trägerfolie auf ihrer der Strukturschicht zugewandten Seite eine Master-Reliefstruktur aufweist und die Strukturschicht auf ihrer der Trägerfolie zugewandten Seite eine zur Master-Reliefstruktur der Trägerfolie komplementäre erste Reliefstruktur aufweist, die insbesondere als Mattstruktur und/ oder als diffraktive Struktur und/ oder als refraktive Struktur und/ oder als Makrostruktur ausgebildet sein kann. Auf ihrer der Trägerfolie abgewandten Seite weist die Strukturschicht ferner eine sich von der ersten Reliefstruktur unterscheidende zweite Reliefstruktur auf. Zur Erzeugung der Master-Reliefstruktur kann vorgesehen sein, auf die Trägerfolie einen UVhärtbaren Replizierlack aufzubringen und während des Aufbringens mit einer Prägewalze die Master-Reliefstruktur einzubringen.

In der Druckschrift DE 10 2007 061 979 A1 ist ein Sicherheitselement mit einem einfallende elektromagnetische Strahlung selektiv beeinflussenden Merkmalsbereich beschrieben. Der Merkmalsbereich enthält metallische Nanostrukturen, in denen durch die einfallende elektromagnetische Strahlung Volumen- oder Oberflächenplasmonen angeregt und/ oder Resonanzerscheinungen hervorgerufen werden. Die beschriebenen Subwellenlängengitter können auch mit einer Beugungsstruktur kombiniert sein.

Ausgehend davon liegt der Erfindung die Aufgabe zugrunde, ein geprägtes Sicherheitselement zu schaffen, das ein ansprechendes visuelles Erscheinungsbild mit hoher Fälschungssicherheit verbindet. Darüber hinaus soll eine Prägeplatte für die Herstellung solcher Sicherheitselemente und ein Herstellungsverfahren für eine solche Prägeplatte angegeben werden.

Diese Aufgabe wird durch die Merkmale der unabhängigen Ansprüche gelöst. Weiterbildungen der Erfindung sind Gegenstand der Unteransprüche.

Die Erfindung stellt eine Prägeplatte nach Anspruch 1 bereit.

Die Angabe, dass die Teilbereiche jeweils paarweise passergenau zueinander angeordnet sind und dass sich die zugehörigen charakteristischen Strukturgrößen der Prägeelemente paarweise um mindestens einen Faktor 1,5 unterscheiden (nachfolgend auch Unterschiedsfaktor genannt) bedeutet dabei, dass diese Bedingungen für jede Kombination von zwei Teilbereichen des Prägereliefs erfüllt sind. Enthält das Prägerelief beispielsweise drei Teilbereiche A, B, C, so sind die genannten Bedingungen im Verhältnis der Teilbereiche A und B, der Teilbereiche A und C und der Teilbereiche B und C erfüllt. Konkret sind also die Teilbereiche A und B passergenau zueinander angeordnet und die charakteristischen Strukturgrößen der Prägeelemente in den Teilbereichen A und B unterscheiden sich um mindestens einen Faktor 1,5. Entsprechendes gilt für die Teilbereiche A und C, und B und C.

Das Prägesubstrat ist mit Vorteil ein Foliensubstrat, es kann sich jedoch auch um ein Papiersubstrat oder ein Hybridsubstrat handeln.

In vorteilhaften Ausgestaltungen unterscheiden sich die charakteristischen Strukturgrößen der Prägeelemente zweier Teilbereiche paarweise um mindestens einen Faktor 2. Enthält das Prägerelief drei oder mehr Teilbereiche, so ist mit Vorteil einer der Unterschiedsfaktoren mindestens gleich 2, einer der Unterschiedsfaktoren mindestens gleich 5 und einer der Unterschiedsfaktoren mindestens gleich 10.

Die Gitterperiode des Subwellenlängengitters liegt insbesondere zwischen 100 nm und 500 nm, vorzugsweise zwischen 240 nm und 420 nm.

Gitterperiode des diffraktiven Gitters liegt insbesondere zwischen 0,5 µm und 3 µm, vorzugsweise zwischen 0,6 µm und 1,2 µm.

Die Rasterperiode der Mikrospiegel- oder Mikrolinsenanordnung liegt insbesondere zwischen 2,5 µm und 100 µm, vorzugsweise zwischen 5 µm und 20 µm.

In bevorzugten Ausgestaltungen enthält das Prägerelief zumindest drei Teilbereiche, wobei ein erster Teilbereich als Prägeelemente ein Mikrospiegelraster und ein zweiter Teilbereich als Prägeelemente ein Subwellenlängengitter oder ein diffraktives Gitter enthält. Besonders bevorzugt ist eine Ausgestaltung, bei der das Prägerelief zumindest drei Teilbereiche enthält, wobei ein erster Teilbereich als Prägeelemente ein Mikrospiegelraster, ein zweiter Teilbereich als Prägeelemente ein Subwellenlängengitter und ein dritter Teilbereich als Prägeelemente ein diffraktives Gitter enthält.

Die Teilbereiche sind mit Vorteil jeweils in Motivform ausgebildet und stellen insbesondere Portraits, Darstellungen von Gegenständen, Tieren oder Pflanzen, Ornamenten, Guillochen oder alphanumerischer Zeichen dar.

Gemäß der Erfindung grenzen die Teilbereiche paarweise direkt aneinander und sind vorzugweise paarweise miteinander verflochten. Zwei Teilbereiche sind dabei miteinander verflochten, wenn es in jedem Teilbereich Punkte gibt, deren Verbindungslinie durch den anderen Teilbereich führt. Die paarweise Verflechtung bedeutet wie oben, dass für jede beliebige Kombination von zwei Teilbereichen des Prägereliefs diese miteinander verflochten sind.

Das Prägerelief besteht in bevorzugten Gestaltungen aus genau drei Teilbereichen mit unterschiedlichen charakteristischen Strukturgrößen der Prägeelemente.

Die Erfindung enthält auch ein Verfahren zur Herstellung einer Prägeplatte der beschriebenen Art, bei dem auf einen Träger
- zunächst in einem ersten Lithografieschritt ein erster Fotolack aufgebracht wird, in Form gewünschter Prägeelemente mit einer ersten Strukturgröße belichtet und entwickelt wird, um einen ersten Teilbereich mit den gewünschten Prägeelementen entsprechenden Strukturelementen mit einer ersten charakteristischen Strukturgröße zu erzeugen, und
- nachfolgend in einem zweiten Lithografieschritt ein zweiter Fotolack aufgebracht wird, in Form gewünschter Prägeelemente mit einer zweiten Strukturgröße belichtet und entwickelt wird, um einen zweiten Teilbereich mit den gewünschten Prägeelementen entsprechenden Strukturelementen mit einer zweiten charakteristischen Strukturgröße zu erzeugen, die sich um mindestens einen Faktor 1,5 von der ersten Strukturgröße unterscheidet.

In einer vorteilhaften Verfahrensführung wird dabei im ersten Lithografie-schritt als erster Fotolack ein E-Beam-Resist aufgebracht und die Belichtung erfolgt mittels Elektronstrahl. Im zweiten Lithografieschritt wird als zweiter Fotolack ein fotosensitver Resist aufgebracht, und die Belichtung erfolgt durch elektromagnetische Strahlung, vorzugsweise durch Laserbestrahlung.

Mit Vorteil werden im ersten Lithografieschritt Strukturelemente in Form eines Subwellenlängengitters oder diffraktiven Gitters erzeugt und/ oder es werden im zweiten Lithografieschritt Strukturelemente in Form eines Mikrospiegelrasters oder Mikrolinsenrasters erzeugt.

In einer vorteilhaften Weiterbildung werden im ersten Lithografieschritt zusätzlich Positionsmarken erzeugt, die im zweiten Lithografieschritt nach dem Aufbringen des zweiten Fotolacks und vor der Einbelichtung der Prägeelemente mit der zweiten Strukturgröße freigelegt werden.

In einer zweckmäßigen Verfahrensvariante wird der zweite Fotolack im zweiten Lithografieschritt auf den entwickelten ersten Fotolack des ersten Lithografieschritts aufgebracht.

Gegenwärtig ist allerdings eine andere Verfahrensvariante besonders bevorzugt, bei der zwischen dem ersten und zweiten Lithografieschritt eine Hilfsabformung der im ersten Lithografieschritt erzeugten Strukturelemente erzeugt wird und der zweite Fotolack im zweiten Lithografieschritt auf eine Zwischenabformung aufgebracht wird, die durch die genannte Hilfsabformung gebildet ist oder durch eine weitere Abformung aus der genannten Hilfsabformung erzeugt wird. Auf diese Weise kann die Prozessstabilität erhöht werden, da eine solche Zwischenabformung sowohl chemisch als auch mechanisch stabiler als die zugrundliegende strukturierte Resistschicht ausgebildet werden kann.

In einer vorteilhaften Verfahrensführung wird die erste Hilfsabformung nicht selbst als Zwischenabformung verwendet, sondern es wird eine zweite Hilfsabformung der ersten Hilfsabformung erzeugt und diese zweite Hilfsabformung als Zwischenabformung zur Aufbringung des zweiten Fotolacks verwendet. In diesem Fall kann neben dem Original aus dem ersten Lithografieschritt auch die erste Hilfsabformung als Sicherungskopie dienen. Zudem weisen die Strukturelemente in der zweiten Hilfsabformung durch die zweimalige invertierende Replikation dieselbe Orientierung wie im Original aus dem ersten Lithografieschritt auf.

Bei einer alternativen Vorgehensweise zur Herstellung einer Prägeplatte der oben beschriebenen Art wird
- ein Träger mit einer ersten Oberflächen-Reliefstruktur in Form gewünschter Prägeelemente mit einer ersten Strukturgröße bereitgestellt,
- in einem Lithografieschritt ein thermoplastischer Fotolack auf den Träger mit der ersten Reliefstruktur aufgebracht und in einem Heißprägeprozess auf der der ersten Reliefstruktur gegenüberliegenden Seite des Fotolacks mit einer zweiten Reliefstruktur in Form gewünschter Prägeelemente mit einer zweiten Strukturgröße versehen, wobei sich die zweite Strukturgröße um mindestens einen Faktor 1,5 von der ersten Strukturgröße unterscheidet, und
- wird der thermoplastische Fotolack lokal unterschiedlich belichtet und dann entwickelt, um in einem ersten Teilbereich die erste Oberflächen-Reliefstruktur freizulegen und in einem zweiten Teilbereich die zweite Reliefstruktur des thermoplastischen Fotolacks zu erhalten.

Bei einer Weiterbildung des Verfahrens wird in dem genannten Belichtungs- und Entwicklungsschritt der thermoplastische Fotolack in einem dritten Teilbereich teilweise aber nicht vollständig entfernt, um dort ein Plateau oder eine weitere Reliefstruktur zu erzeugen, welche vorteilhaft in Form gewünschter Prägeelemente mit einer dritten Strukturgröße versehen wird, die sich von der ersten und zweiten Strukturgröße jeweils um mindestens einen Faktor 1,5 unterscheidet.

Die Passerung des ersten und zweiten und gegebenenfalls dritten Teilbereichs ergibt sich dabei automatisch durch die lokal unterschiedlich Belichtung des thermoplastischen Fotolacks in einem einzigen Belichtungsschritt. Der erste, zweite und gegebenenfalls dritte Teilbereich sind mit Vorteil jeweils in Motivform ausgebildet und stellen insbesondere Portraits, Darstellungen von Gegenständen, Tieren oder Pflanzen, Ornamenten, Guillochen oder alphanumerischer Zeichen dar. In einer vorteilhaften Ausgestaltung sind die Teilbereiche paarweise miteinander verflochten.

Bei einer weiteren alternativen Vorgehensweise zur Herstellung einer Prägeplatte der oben beschriebenen Art wird
- auf einen Träger ein Kombi-Resist aufgebracht, der sowohl für Elektronenstahlbelichtung als auch für Laserbelichtung empfindlich ist,
- wird der Kombi-Resist in einem Belichtungsschritt E) mit einem Elektronenstrahlschreiber in Form gewünschter Prägeelemente mit einer ersten Strukturgröße belichtet,
- wird der Kombi-Resist in einem Belichtungsschritt L) mit einem Laserschreiber in Form gewünschter Prägeelemente mit einer zweiten Strukturgröße belichtet, wobei sich die zweite Strukturgröße um mindestens einen Faktor 1,5 von der ersten Strukturgröße unterscheidet, und
- wird der in den Belichtungsschritten E) und L) belichtete Kombi-Resist entwickelt, um gleichzeitig einen ersten Teilbereich mit den gewünschten Prägeelementen entsprechenden Strukturelementen mit der ersten charakteristischen Strukturgröße und einen zweiten Teilbereich mit den gewünschten Prägeelementen entsprechenden Strukturelementen mit der zweiten charakteristischen Strukturgröße zu erzeugen.

Der Belichtungsschritt E) wird dabei vorteilhaft vor dem Belichtungsschritt L) ausgeführt, da dann der Dosiseintrag der Belichtung im Substrat noch geringer ist. Grundsätzlich ist jedoch auch die umgekehrte Reihenfolge möglich. Der erste und zweite Teilbereich sind mit Vorteil jeweils in Motivform ausgebildet und stellen insbesondere Portraits, Darstellungen von Gegenständen, Tieren oder Pflanzen, Ornamenten, Guillochen oder alphanumerischer Zeichen dar.

Der erste und zwei Teilbereich sind zueinander gepassert, was beispielsweise durch die Verwendung von Positionsmarken oder anderen Strukturierungen des Trägers sichergestellt werden kann. Dazu können beispielsweise vor der Belackung Positionsmarken in den Träger geätzt oder der Träger kann auf andere Weise strukturiert werden. Nach der Belackung mit dem Kombi-Resist werden die Belichtungsschritte E) und L) marken- oder strukturgestützt durchgeführt. Die Positionsmarken bzw. Strukturierungen können zu diesem Zweck vor den Belichtungsschritten E) und L) freigelegt werden, um eine genauere Positionierung zu ermöglichen.

In einer vorteilhaften Ausgestaltung dieser Herstellungsvariante sind die Teilbereiche paarweise miteinander verflochten. Alternativ oder zusätzlich grenzen die Teilbereiche paarweise direkt aneinander an.

In allen beschriebenen Herstellungsverfahrensvarianten kann die gewünschte Prägeplatte aus dem mit Strukturelementen versehenen Träger beispielsweise durch galvanische Abformung oder in einem Nanoimprint-Verfahren erzeugt werden.

Die Erfindung enthält schließlich auch ein Sicherheitselement mit einem geprägten Gesamtmotiv aus zumindest drei Teilbereichen mit unterschiedlichem optischem Erscheinungsbild. Dabei ist vorgesehen, dass
- die Teilbereiche motivförmig ausgebildet und jeweils paarweise passergenau zueinander angeordnet sind, wobei die Teilbereiche paarweise direkt aneinander grenzen und
- in jedem Teilbereich das Prägerelief aus einer Vielzahl von Prägeelementen mit einer charakteristischen Strukturgröße vorliegt, wobei sich die charakteristischen Strukturgrößen der Prägeelemente zweier Teilbereiche paarweise um mindestens einen Faktor 1,5 unterscheiden.

Dabei enthält einer der Teilbereiche als Prägeelemente ein Subwellenlängengitter, wobei die charakteristische Strukturgröße der Prägeelemente die Gitterperiode des Subwellenlängengitters ist, und/ oder einer der Teilbereiche enthält als Prägeelemente ein diffraktives Gitter, wobei die charakteristische Strukturgröße der Prägeelemente die Gitterperiode des diffraktiven Gitters ist, und/ oder einer der Teilbereiche enthält als Prägeelemente ein Mikrospiegelraster oder Mikrolinsenraster, wobei die charakteristische Strukturgröße der Prägeelemente die Rasterperiode der Mikrospiegel oder Mikrolinsen ist.

Die Gitterperiode des Subwellenlängengitters liegt insbesondere zwischen 100 nm und 500 nm, vorzugsweise zwischen 240 nm und 420 nm, die Gitterperiode des diffraktiven Gitters liegt insbesondere zwischen 0,5 µm und 3 µm, vorzugsweise zwischen 0,6 µm und 1,2 µm, und/oder die Rasterperiode der Mikrospiegel- oder Mikrolinsenanordnung liegt insbesondere zwischen 2,5 µm und 100 µm, vorzugsweise zwischen 5 µm und 20 µm.

Weitere Ausführungsbeispiele sowie Vorteile der Erfindung werden nachfolgend anhand der Figuren erläutert, bei deren Darstellung auf eine maßstabs- und proportionsgetreue Wiedergabe verzichtet wurde, um die Anschaulichkeit zu erhöhen.

Es zeigen:
- Fig.1: eine schematische Darstellung einer Banknote mit einem Folienpatch, in den ein erfindungsgemäßes Sicherheitselement eingeprägt ist,
- Fig. 2: das Sicherheitselement der Fig. 1 genauer,
- Fig. 3: in (a) bis (d) Zwischenschritte bei der Herstellung einer Prägeplatte nach einem Ausführungsbeispiel der Erfindung,
- Fig. 4: in (a) bis (d) Zwischenschritte bei der Herstellung einer Prägeplatte nach einem anderen Ausführungsbeispiel der Erfindung,
- Fig. 5: in (a) bis (d) Zwischenschritte bei der Herstellung einer Prägeplatte nach einem weiteren Ausführungsbeispiel der Erfindung,
- Fig.6: in (a) bis (c) Zwischenschritte bei der Herstellung einer Prägeplatte nach einer alternativen Vorgehensweise, und
- Fig.7: eine erfindungsgemäße Nickel-Prägeplatte wie sie beispielsweise mit dem Verfahren der Fig. 3 herstellt werden kann.

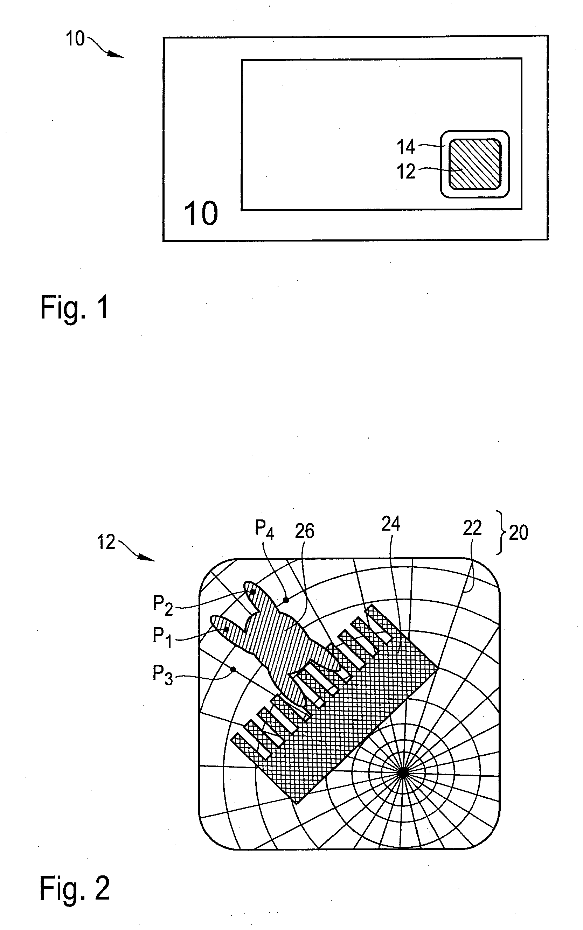

Die Erfindung wird nun am Beispiel von Sicherheitselementen für Banknoten erläutert. Figur 1 zeigt dazu eine schematische Darstellung einer Banknote 10, die mit einem Transferelement in Form eines Folienpatches 14 versehen ist, in den ein erfindungsgemäßes Sicherheitselement 12 eingeprägt ist. Die Erfindung ist allerdings nicht auf das zur Illustration gezeigte Transferelement bei Banknoten beschränkt, sondern kann beispielsweise auch bei Sicherheitsfäden, breiten Sicherheitsstreifen oder Abdeckfolien eingesetzt werden, die über einem opaken Bereich, einem Fensterbereich oder einer durchgehenden Öffnung eines beliebigen Datenträgers angeordnet sind.

Das in Fig. 2 genauer dargestellte Sicherheitselement 12 zeigt ein geprägtes Gesamtmotiv 20, das aus drei geprägten Teilmotiven besteht, die in der Figur schematisch durch ein Linienmuster 22, ein Rechteck mit Kammstruktur 24 und eine gerundete Struktur 26 dargestellt sind. In der Praxis stellen das Gesamtmotiv und die Teilmotive typischerweise komplexe visuelle Gestaltungen dar, beispielsweise kann das Linienmuster 22 durch ein Spinnennetz, das Rechteck 24 durch eine realistische Darstellung eines Schmetterlings und die gerundete Struktur 26 durch eine realistische dreidimensional wirkende Darstellung einer Spinne gebildet sein.

Die Besonderheit des Sicherheitselements 12 besteht nun insbesondere darin, dass die geprägten Teilbereiche 22, 24, 26 nicht nur unterschiedliche Teilmotive darstellen, sondern dem Betrachter jeweils ein grundlegend unterschiedliches optisches Erscheinungsbild bzw. unterschiedliche optisch variable Effekte zeigen, dass die Teilbereiche 22, 24, 26 aber dennoch nicht einfach blockweise nebeneinander liegen, sondern paarweise miteinander verflochten und zueinander gepassert sind.

Wie oben erläutert, sind zwei Teilbereiche miteinander verflochten, wenn es in jedem Teilbereich Punkte gibt, deren Verbindungslinie durch den anderen Teilbereich führt. Beispielsweise sind die Teilbereiche 26 und 22 miteinander verflochten, weil die Verbindungslinie der Punkte P₁ und P₂ des Teilbereichs 26 eine der Linien des Linienmusters 22 schneidet und daher durch den Teilbereich 22 verläuft, und weil umgekehrt die Verbindungslinie der Punkte P₃ und P₄ des Teilbereichs 22 durch den Teilbereich 26 führt. Entsprechend sind die Teilbereiche 26 und 24 und die Teilbereiche 24 und 22 miteinander verflochten.

Die unterschiedlichen Erscheinungsbilder bzw. die unterschiedlichen optisch variablen Effekte beruhen dabei darauf, dass in den Teilbereichen 22, 24, 26 jeweils ein Prägerelief aus einer Vielzahl von Prägeelementen mit einer charakteristischen Struktur größe vorliegt, wobei sich die charakteristischen Strukturgrößen der Prägeelemente zweier Teilbereiche paarweise um mindestens einen Faktor 1,5 unterscheiden. Die Angabe, dass sich die Strukturgrößen zweier Teilbereiche paarweise um mindestens einen Faktor 1,5 unterscheiden, bedeutet dabei im vorliegenden Zusammenhang, dass sich die Strukturgrößen der Prägeelemente der Teilbereiche 22 und 24 um mindestens einen Faktor 1,5 unterscheiden, ebenso die Strukturgrößen der Prägeelemente der Teilbereiche 22 und 26 und der Teilbereiche 24 und 26.

Im Ausführungsbeispiel ist der geprägte Teilbereich 24 durch Subwellenlängenstrukturen gebildet, die Farben in Reflexion und auch in Transmission erzeugen, wobei der Farbeindruck abhängig von der konkreten verwendeten Geometrie der Nanostrukturen sowohl betrachtungswinkelabhängig als auch beim Kippen farbstabil sein kann. Der geprägte Teilbereich 22 ist im Ausführungsbeispiel durch diffraktive Gitter gebildet, die Spektralfarben in der ersten Beugungsordnung und damit eine vom Betrachtungswinkel abhängige Farbvariation zeigen. Schließlich ist der Teilbereich 26 im Ausführungsbeispiel durch ein Mikrospiegelraster gebildet, dass wegen der Größe der Mikrospiegel achromatisch erscheint und 3D- und/ oder Bewegungseffekte zeigt.

Konkret beträgt im Ausführungsbeispiel die Gitterkonstante der Subwellenlängenstrukturen im Teilbereich 24 beispielsweise 250 nm, die Gitterkonstante des diffraktiven Gitters im Teilbereich 22 beispielsweise 0,75 µm und die Rasterperiode des Mikrospiegelrasters im Teilbereich 26 beispielsweise 12 µm. Der Unterschiedsfaktor der Teilbereiche 22 und 24 beträgt dann 0,75 µm/250 nm = 3, der Unterschiedsfaktor der Teilbereiche 26 und 22 beträgt 12 µm/0,75 µm = 16 und der Unterschiedsfaktor der Teilbereiche 26 und 24 beträgt 12 µm/250 nm = 48.

Durch eine solche Kombination unterschiedlicher Strukturtypen, wie den genannten Subwellenlängengittern, diffraktiven Gittern, Mikrospiegel- oder auch Mikrolinsenrastern jeweils in Motivform, können einerseits visuell abwechslungsreiche und attraktive Erscheinungsbilder erzeugt werden und wird andererseits durch die erhöhte Herstellungskomplexität eine besonders hohe Fälschungssicherheit sichergestellt.

Eine besondere Herausforderung besteht bei solchen kombinierten Strukturen allerdings in der passergenauen Erzeugung der motivförmig ausgebildeten und miteinander verflochtenen Teilbereiche mit den stark unterschiedlichen Strukturgrößen ihrer Prägeelemente, die eine Herstellung der Teilbereiche mit einem einzigen Verfahren unmöglich machen.

Erfindungsgemäß kann zur Herstellung einer Prägeplatte zum Einprägen eines gewünschten Motivs, das zumindest zwei Teilbereiche mit unterschiedlichem optischem Erscheinungsbild enthält, beispielsweise wie folgt vorgegangen werden, wobei zur Illustration zunächst von zwei Teilbereichen mit unterschiedlichen Strukturgrößen ausgegangen wird. Die Herstellung einer Prägeplatte erfolgt dabei sukzessive in zumindest zwei separaten Lithografieschritten, die für die Strukturgröße der Prägeelemente des jeweiligen Teilbereichs besonders angepasst sind.

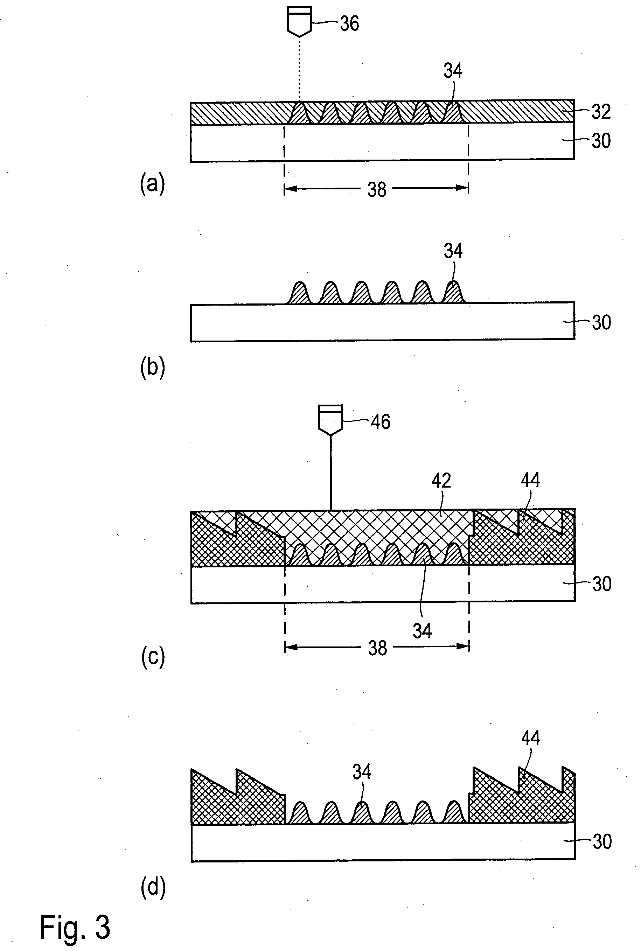

Bei einer ersten Verfahrensvariante wird mit Bezug auf Fig. 3(a) ein geeigneter Träger 30, beispielsweise ein Quarzsubstrat, bereitgestellt und mit einem E-Beam-Resist 32 belackt. Dann werden mit einem Elektronenstrahlschreiber 36 in einem motivförmigen Bereich 38 Nanostrukturen 34 in Form der gewünschten Prägeelemente, im Ausführungsbeispiel in Form von Subwellenlängenstrukturen, in den E-Beam-Resist 32 einbelichtet. Die Nanostrukturen 34 können die gewünschten Prägeelemente dabei in positiver oder negativer Form darstellen, je nachdem ob ein positiver oder negativer Resist verwendet wird und je nach der Anzahl der invertierenden Umkopierschritte im weiteren Verfahrensgang. Der belichtete Teil des E-Beam-Resists 32 ist in Fig. 3(a) durch eine engere Schraffur hervorgehoben, wobei im Ausführungsbeispiel ein negativer Resist verwendet wird, nach der Entwicklung also die belichteten Bereiche stehen bleiben. In dem Elektronenstrahl-Belichtungsschritt werden in einer vorteilhaften Ausgestaltung zusätzlich in den Figuren nicht dargestellte Positionsmarken im Resist 32 erzeugt, die der exakten Positionierung der unterschiedlichen Teilbereiche dienen.

Der Resist 32 wird entwickelt, um die den späteren Prägeelementen entsprechenden Strukturelemente 34 und die Positionsmarken im Resist 32 freizulegen, wie in Fig. 3(b) gezeigt. Um die Beständigkeit des E-Beam-Resists 32 für die nachfolgenden Prozessschritte zu erhöhen, wird der Resist 32 zudem bei hoher Temperatur getempert. Vorzugsweise wird als Resist 32 wie im Ausführungsbeispiel ein Negativ-Resist eingesetzt, der sich zuvor durch intensive UV-Bestrahlung zusätzlich vernetzen und dadurch in seiner Beständigkeit weiter verbessern lässt.

Mit Bezug auf Fig. 3(c) wird dann in einem zweiten Lithografieschritt direkt auf die freigelegten Strukturelemente 34 ein fotosensitver Resist 42 aufgebracht. In den Resist 42 werden mit Hilfe des fokussierten Laserstrahls eines Laserschreibers 46 in einem motivförmigen Bereich Mikrostrukturen 44 in Form der gewünschten Prägeelemente, im Ausführungsbeispiel in Form eines Mikrospiegelrasters, in den fotosensitven Resist 42 einbelichtet. Die Mikrostrukturen 44 können die gewünschten Prägeelemente dabei in positiver oder negativer Form darstellen, je nachdem ob ein positiver oder negativer Resist verwendet wird und je nach der Anzahl der invertierenden Umkopierschritte im weiteren Verlauf des Verfahrens. Der belichtete Teil des fotosensitven Resists 42 ist in Fig. 3(c) durch eine weite Schraffur hervorgehoben, wobei im Ausführungsbeispiel ein positiver Resist verwendet wird, bei der Entwicklung also die belichteten Bereiche entfernt werden. Die im ersten Lithografieschritt erzeugten Strukturelemente 34 werden im zweiten Lithografieschritt durch den fotosensitven Resist 42 zunächst verdeckt, durch eine Belichtung des von den Strukturelementen 34 belegten Bereichs 38 mit entsprechend hoher Strahlungsdosis bei der Entwicklung aber freigelegt.

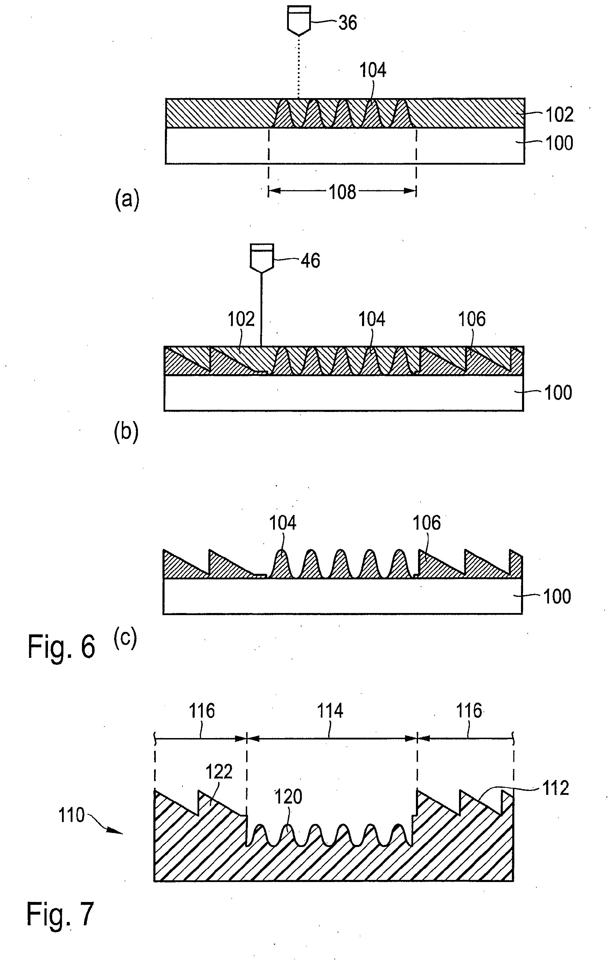

Schließlich wird auch der Resist 42 entwickelt, um die den späteren Prägeelementen entsprechenden Strukturelemente 34 und 44 freizulegen, wie in Fig. 3(d) gezeigt. Aus dem mit den Strukturelementen 34 und 44 versehenen Träger 30 kann dann in an sich bekannter Weise beispielsweise durch galvanische Abformung oder in einem Nanoimprint-Verfahren die gewünschte Prägeplatte als Original erzeugt werden, wie in Fig. 7 gezeigt.

Mit Hilfe von in den Resist 32 einbelichteten Positionsmarken kann eine besonders hohe Positioniergenauigkeit des zweiten Lithografieschritts von weniger als 1 µm erreicht werden. Dazu werden nach dem Aufbringen des Resists 42 zunächst nur die Positionsmarken großflächig freigelegt und die freigelegten Positionsmarken dann zur exakten Positionierung des Laserschreibers 46 verwendet. Anschließend können die Mikrostrukturen 44 wie beschrieben exakt zu den Strukturelementen 34 gepassert in den Resist 42 einbelichtet werden.

Während die beschriebene Reihenfolge der beiden Lithografieschritte gegenwärtig bevorzugt ist, kann sie grundsätzlich auch umgekehrt werden, so dass zunächst die Mikrostrukturen 44 auf dem Träger 30 und danach die Nanostrukturen 34 auf den Mikrostrukturen 44 erzeugt werden.

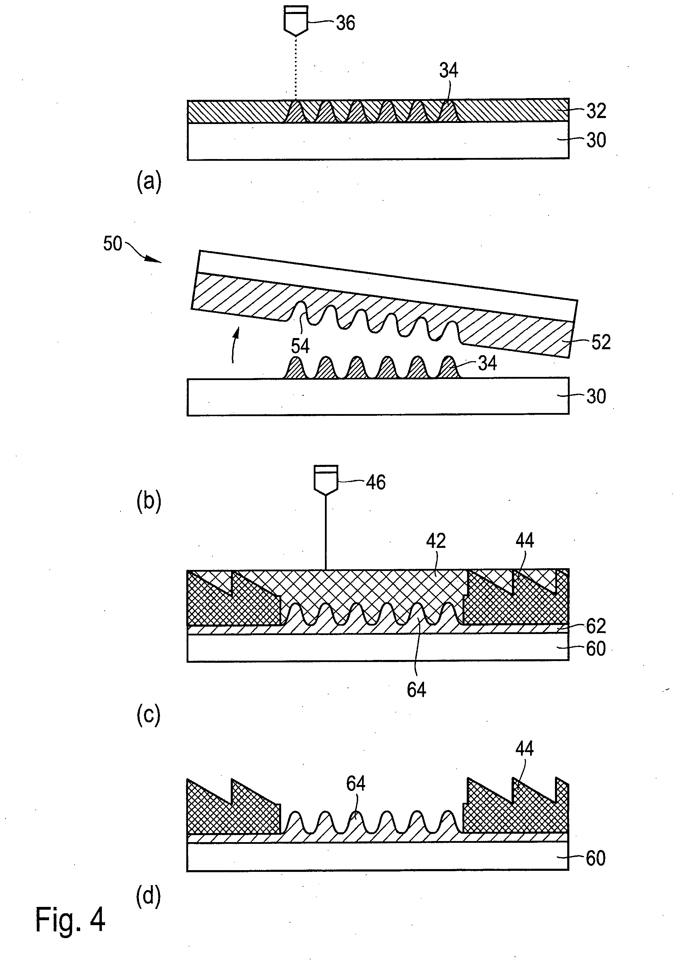

Bei einer alternativen, gegenwärtig besonders bevorzugten Verfahrensvariante wird nach dem ersten Lithografieschritt zur Verbesserung der Prozessstabilität eine Zwischenabformung der Nanostrukturen erzeugt, wie nachfolgend mit Bezug auf Fig. 4 näher erläutert.

Zunächst wird wie bei der oben beschriebenen Verfahrensvariante ein geeigneter Träger 30 bereitgestellt, mit einem E-Beam-Resist 32 belackt, und es werden mit einem Elektronenstrahlschreiber 36 Nanostrukturen 34 in Form der gewünschten Prägeelemente in einem motivförmigen Bereich in den E-Beam-Resist 32 einbelichtet, wie in Fig. 4(a) dargestellt. Für die exakte Positionierung werden zudem nicht dargestellte Positionsmarken im Resist 32 erzeugt. Der Resist 32 wird entwickelt, um die den späteren Prägeelementen entsprechenden Strukturelemente 34 und die Positionsmarken im Resist 32 freizulegen, wie in der unteren Bildhälfte der Fig. 4(b) gezeigt.

Dann wird mit Hilfe eines für Abformungen geeigneten Materials, wie z. B. eines UV-härtenden Hybridpolymers 52, wie etwa ORMOCER^{®}, als Hilfsabformung ein erstes Replikat 50 der freigelegten Strukturelemente 34 erzeugt, in dem die Nanostrukturen in negativer Form als abgeformte Strukturelemente 54 vorliegen, wie in Fig. 4(b) dargestellt. Von diesem ersten Replikat 50 wird durch eine weitere Hilfsabformung mit einem UV-härtenden Hybridpolymer 62, beispielsweise wiederum einem ORMOCER^{®}, ein zweites Replikat 60 erzeugt, in dem die Nanostrukturen 34 durch die zweimalige invertierende Replikation wieder in positiver Form als abgeformte Strukturelemente 64 vorliegen, wie in Fig. 4(c) gezeigt. Dieses zweite Replikat 60 wird als Zwischenabformung der zugrundliegenden strukturierten Resistschicht verwendet und als Träger für den zweiten Lithografieschritt eingesetzt.

Die Verwendung einer solchen Zwischenabformung 60 hat mehrere prozesstechnische Vorteile. So ist eine ORMOCER^{®}-Zwischenabformung 60 einerseits sowohl chemisch als auch mechanisch stabiler als die zugrundliegende strukturierte Resistschicht. Auch stellt die Zwischenabformung 60 eine Sicherungskopie des E-Beam-Originals 30, 34 dar, dessen Herstellung im Gesamtprozess in der Regel den größten Zeitaufwand erfordert.

Für die Weiterverarbeitung kann nicht nur, wie im Ausführungsbeispiel der Fig. 4, das zweite Replikat 60, sondern grundsätzlich auch bereits das erste Replikat 50 eingesetzt werden. Die Verwendung eines zweiten Replikats 60 hat aber den Vorteil, dass das erste Replikat 50 als zusätzliche Sicherungskopie des E-Beam-Originals zur Verfügung steht und dass zudem die Orientierung der Nanostrukturen 34 im E-Beam-Original und die Orientierung der Strukturelemente 64 im zweiten Replikat 60 übereinstimmt. Bei Gitterstrukturen mit im Wesentlichen sinusförmigem Querschnitt hat die Orientierung der Strukturen zwar keine große Bedeutung, bei vielen Nanostrukturen macht es jedoch sehr wohl einen Unterschied, ob die Nanostrukturen als Zapfen oder Löcher vorliegen. Gegebenenfalls können die gewünschten Strukturen im E-Beam-Original in invertierter Form in den Resist 32 eingeschrieben werden, was prinzipiell bei allen Strukturformen möglich ist, allerdings zu Unterschieden in der Schreibdauer führen kann.

Anstelle einer Hilfsabformung mit einem UV-härtenden Hybridpolymer kann das erste und/ oder zweite Replikat auch durch eine Abformung mit PDMS (Polydimethylsiloxan) oder eine galvanische Abformung, beispielsweise in Nickel, erzeugt werden, oder es kann ein Ätzverfahren eingesetzt werden um die Nanostrukturen 34 des ersten Lithografieschritts in eine Hilfsabformung zu übertragen. In allen Fällen entsteht eine für die Weiterverarbeitung geeignete, besonders haltbare Zwischenkopie der Nanostrukturen.

Zurückkommend auf die Darstellung der Fig. 4(c) wird in einem zweiten Lithografieschritt auf die Strukturelemente 64 der Zwischenabformung.60 ein fotosensitver Resist 42 aufgebracht. In den Resist 42 werden wie im Ausführungsbeispiel der Fig. 3 mit Hilfe des fokussierten Laserstrahls eines Laserschreibers 46 in einem motivförmigen Bereich Mikrostrukturen 44 in Form der gewünschten Prägeelemente, im Ausführungsbeispiel in Form eines Mikrospiegelrasters, in den fotosensitven Resist 42 einbelichtet.

Der Resist 42 wird entwickelt, um die den späteren Prägeelementen entsprechenden Strukturelemente 64 und 44 freizulegen, wie in Fig. 4(d) gezeigt. Aus der mit den Strukturelementen 64 und 44 versehenen Zwischenabformung 60 kann dann in an sich bekannter Weise beispielsweise durch galvanische Abformung oder in einem Nanoimprint-Verfahren die gewünschte Prägeplatte als Original erzeugt werden.

Das beschriebene Herstellungsverfahren ist nicht auf zwei Teilbereiche mit unterschiedlichen Strukturgrößen beschränkt. Vielmehr kann nach jedem Lithografieschritt über eine oder mehrere Hilfsabformungen eine Zwischenabformung erzeugt und als Träger für den nächsten Lithografieschritt verwendet werden, so dass eine praktisch beliebige Anzahl an gepasserten Teilbereichen mit unterschiedlichen Strukturgrößen erzeugt werden kann. In der Praxis ist insbesondere eine Kombination von drei unterschiedlichen Strukturgrößen wichtig, nämlich einem Subwellenlängengitter, einem diffraktiven Gitter und einer Mikrostruktur in Form eines Mikrospiegel- oder Mikrolinsenrasters. Das Subwellenlängengitter und das diffraktive Gitter werden dabei vorteilhaft mittels Elektronenstrahl, die Mikrostruktur mit Hilfe eines Laserschreibers in dem jeweiligen Resist erzeugt.

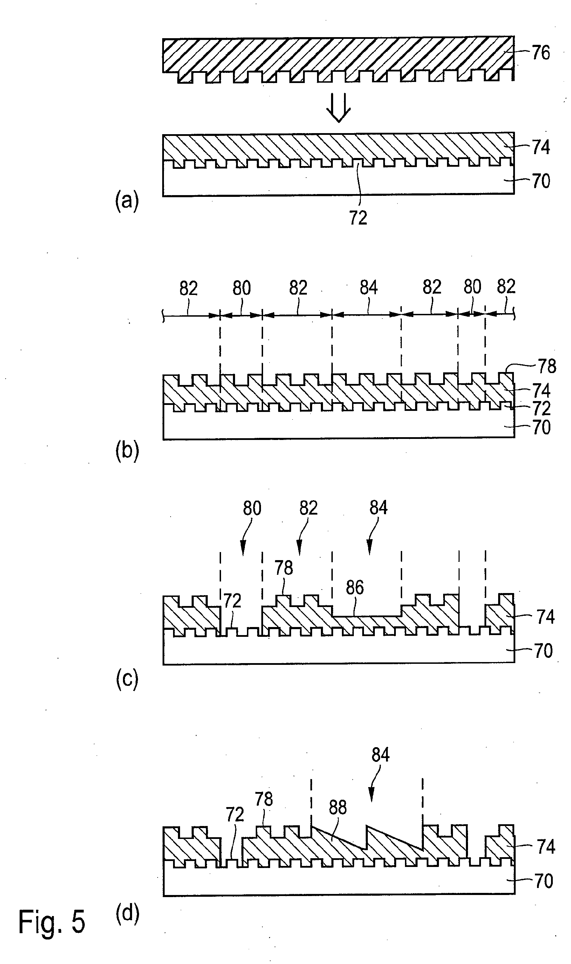

Bei einer weiteren, mit Bezug auf Fig. 5 näher erläuterten Verfahrensvariante wird von einem Träger 70 ausgegangen, der bereits ein erstes Oberflächenrelief 72, beispielsweise in Form eines Subwellenlängengitters enthält. Das Oberflächenrelief 72 liegt dabei vorteilhaft als Hybridpolymer-Abformung, galvanische Abformung, beispielsweise in Nickel, oder als geätztes Substrat vor. Es kann beispielsweise wie im Zusammenhang mit Fig. 4 beschrieben erzeugt sein oder aus einer externen Quelle stammen.

Der Träger 70 mit dem Oberflächenrelief 72 wird in einem Lithografieschritt mit einem fotosensitven, thermoplastischen Resist 74 beschichtet, wie in Fig. 5(a) dargestellt. Dann wird einem Heißprägeprozess in den thermoplastischen Resist 74 mit Hilfe eines Prägestempels 76 eine zweite, unterschiedliche Reliefstruktur 78, beispielsweise ein diffraktives Gitter eingebracht, wie in Fig. 5(b) schematisch gezeigt.

Anschließend können durch geeignete lokale Belichtung etwa mit einem Laserschreiber in einem Teilbereich 80 das erste Oberflächenrelief 72 freigelegt werden, in einem anderen Teilbereich die zweite Reliefstruktur 78 des Resists 74 erhalten werden und gegebenenfalls in einem weiteren Teilbereich zusätzliche Strukturen einbelichtet werden. Beispielsweise wird der Resist 74 im Ausführungsbeispiel der Fig. 5 in einem ersten motivförmigen Teilbereich 80 durchbelichtet, in einem zweiten motivförmigen Teilbereich 82 nicht belichtet und in einem dritten motivförmigen Teilbereich 84 nicht vollständig durchbelichtet.

Wie in Fig. 5(c) gezeigt, wird bei einem negativen Resist 74 der Resist dann bei der Entwicklung in dem Teilbereich 80 entfernt, so dass dort ein motivförmiger Bereich mit dem ersten Oberflächenrelief 72 in Form des vorgegebenen Subwellenlängengitters entsteht. Im Teilbereich 82 bleibt der Resist 74 erhalten, so dass dort ein motivförmiger Bereich mit der zweiten Reliefstruktur 78 in Form des eingeprägten diffraktives Gitters entsteht. Im Teilbereich 84 wird der Resist 74 teilweise entfernt, so dass dort jeweils ein Plateau 86 entsteht.

Bei einer ausreichend dicken Resistschicht 74 kann mit Hilfe eines Laserschreibers auch eine weitere Reliefstruktur 88, beispielsweise ein Mikrospiegel- oder Mikrolinsenraster, in dem Teilbereich 84 erzeugt werden. Auf diese Weise entstehen insgesamt drei Teilbereiche mit Reliefstrukturen unterschiedliche Strukturgröße (Subwellenlängengitter 72, diffraktives Gitter 78, Mikrospiegelraster 88), wie in Fig. 5(d) dargestellt.

Bei einer alternativen Vorgehensweise kann zur Herstellung einer Prägeplatte anstelle eines sukzessiven Aufbaus mit mehreren Lithografieschritten auch ein Kombi-Resist verwendet werden, der sowohl für Elektronenstahlbelichtung als auch für Laserbelichtung geeignet ist, so dass die unterschiedlich großen Strukturen in einem einzigen Lithografieschritt erzeugt werden können.

Mit Bezug auf Fig. 6(a) wird hierzu auf einem geeigneten Träger 100 ein solcher Kombi-Resist 102 aufgebracht, wobei zur Illustration die Vorgehensweise bei einem Positivresist erläutert wird. Nach dem Belacken des Trägers werden zunächst mit einem Elektronenstrahlschreiber 36 in einem motivförmigen Bereich 108 Nanostrukturen 104 in Form der gewünschten Prägeelemente, im Ausführungsbeispiel in Form von Subwellenlängenstrukturen, in den Kombi-Resist 102 einbelichtet, wie in Fig. 6(a) gezeigt.

Anschließend werden mit Hilfe des fokussierten Laserstrahls eines Laserschreibers 46 in einem motivförmigen Bereich Mikrostrukturen 106 in Form der gewünschten Prägeelemente, im Ausführungsbeispiel in Form eines Mikrospiegelrasters, in den Kombi-Resist 102 einbelichtet, wie in Fig. 6(b) dargestellt. Der belichtete Teil des Kombi-Resists 102 ist in Fig. 6(a) und (b) jeweils durch eine weite Schraffur hervorgehoben. Da ein positiver Resist verwendet wird, werden bei der Entwicklung die belichteten Bereiche entfernt, während die unbelichteten Bereiche in Form der Nanostrukturen 104 und der Mikrostrukturen 106 stehen bleiben, wie in Fig. 6(c) illustriert. Die Strukturen 104, 106 werden dabei nebeneinander erzeugt. Aus dem mit den Strukturelementen 104 und 106 versehenen Träger 100 kann dann in an sich bekannter Weise beispielsweise durch galvanische Abformung oder in einem Nanoimprint-Verfahren die gewünschte Prägeplatte als Original erzeugt werden.

Um die Passergenauigkeit der Teilbereiche mit den Strukturen 104 und 106 sicherzustellen, werden vor der Belackung Positionsmarken in den Träger 100 geätzt oder der Träger 100 wird auf andere Weise strukturiert. Nach der Belackung werden die Belichtungsschritte mit dem Elektronenstrahlschreiber 36 und dem Laserschreiber 46 markengestützt oder strukturgestützt durchgeführt, wobei die Positionsmarken oder Strukturierungen zu diesem Zweck vorab freigelegt werden können.

Figur 7 zeigt eine Nickel-Prägeplatte 110 zum Einprägen eines gewünschten Motivs aus zwei Teilbereichen mit unterschiedlichem optischem Erscheinungsbild in ein Prägesubstrat, wie sie beispielsweise mit dem in Zusammenhang mit Fig. 3 beschriebenen Verfahren herstellt werden kann. Die Prägeplatte 110 ist mit einem Prägerelief 112 in Form des invertierten gewünschten Motivs versehen, und enthält zwei passergenau zueinander angeordnete Teilbereiche 114, 116.

Im Teilbereich 114 ist das Prägerelief 112 durch Prägeelemente in Form von Subwellenlängenstrukturen 120 gebildet, wobei die Gitterkonstante des Subwellenlängengitters von g = 250 nm die charakteristische Strukturgröße der Prägeelemente des Teilbereichs 114 darstellt.

Im Teilbereich 116 ist das Prägerelief 112 durch Prägeelemente in Form von Mikrospiegeln 122 gebildet, wobei die Rasterperiode des Mikrospiegelrasters von r = 12 µm die charakteristische Strukturgröße der Prägeelemente des Teilbereichs 116 darstellt. Der Unterschiedsfaktor der charakteristischen Strukturgrößen der Teilbereiche 116 und 114 beträgt 12 µm/250 nm = 48.

Mit Hilfe der Prägeplatte 110 kann das Prägerelief 112 und damit das gewünschte Motiv in an sich bekannter Weise in ein Prägesubstrat, beispielsweise ein Folienelement oder ein Papiersubstrat eingeprägt werden.

### Bezugszeichenliste

- 10: Banknote
- 12: Sicherheitselement
- 14: Folienpatch
- 20: Gesamtmotiv
- 22, 24, 26: Teilbereiche
- 30: Träger
- 32: E-Beam-Resist
- 34: Nanostrukturen
- 36: Elektronenstrahlschreiber
- 38: motivförmiger Bereich
- 42: fotosensitver Resist
- 44: Mikrostrukturen
- 46: Laserschreiber
- 50: erstes Replikat
- 52: Hybridpolymer
- 54: abgeformte Strukturelemente
- 60: zweites Replikat
- 62: Hybridpolymer
- 64: abgeformte Strukturelemente
- 70: Träger
- 72: erstes Oberflächenrelief
- 74: fotosensitver, thermoplastischer Resist
- 76: Prägestempel
- 78: zweite Reliefstruktur
- 80, 82, 84: Teilbereiche
- 86: Plateau
- 88: weitere Reliefstruktur
- 100: Träger
- 102: Kombi-Resist
- 104: Nanostrukturen
- 106: Mikrostrukturen
- 108: motivförmiger Bereich
- 110: Nickel-Prägeplatte
- 112: Prägerelief
- 114,116: Teilbereiche
- 120: Subwellenlängenstrukturen
- 122: Mikrospiegel

## Patentansprüche

1. Prägeplatte (110) zum Einprägen eines gewünschten Motivs (20), das zumindest drei Teilbereiche (22, 24, 26) mit unterschiedlichem optischem Erscheinungsbild enthält, in ein Prägesubstrat, wobei
- die Prägeplatte mit einem Prägerelief (112) in Form des invertierten gewünschten Motivs versehen ist,
- das Prägerelief zumindest drei, jeweils paarweise passergenau zueinander angeordnete Teilbereiche enthält, wobei die Teilbereiche paarweise direkt aneinander grenzen,
- wobei in jedem Teilbereich das Prägerelief aus einer Vielzahl von Prägeelementen mit einer charakteristischen Strukturgröße besteht, und sich die charakteristischen Strukturgrößen der Prägeelemente zweier Teilbereiche paarweise um mindestens einen Faktor 1,5 unterscheiden,
wobei einer der Teilbereiche als Prägeelemente ein Subwellenlängengitter enthält und die charakteristische Strukturgröße der Prägeelemente die Gitterperiode des Subwellenlängengitters ist, und/ oder einer der Teilbereiche als Prägeelemente ein diffraktives Gitter enthält und die charakteristische Strukturgröße der Prägeelemente die Gitterperiode des diffraktiven Gitters ist, und/ oder einer der Teilbereiche als Prägeelemente ein Mikrospiegelraster oder Mikrolinsenraster enthält und die charakteristische Strukturgröße der Prägeelemente die Rasterperiode der Mikrospiegel oder Mikrolinsen ist.

2. Prägeplatte nach Anspruch 1, **dadurch gekennzeichnet, dass** die Teilbereiche jeweils in Motivform ausgebildet sind.

3. Prägeplatte nach Anspruch 1 oder 2, **dadurch gekennzeichnet, dass** die Teilbereiche paarweise miteinander verflochten sind.

4. Prägeplatte nach wenigstens einem der Ansprüche 1 bis 3, **dadurch gekennzeichnet, dass** einer Unterschiedsfaktoren mindestens gleich 2, einer der Unterschiedsfaktoren mindestens gleich 5 und einer der Unterschiedsfaktoren mindestens gleich 10 ist.

5. Prägeplatte nach wenigstens einem der Ansprüche 1 bis 4, **dadurch gekennzeichnet, dass** das Prägerelief aus genau drei Teilbereichen besteht.

6. Verfahren zur Herstellung einer Prägeplatte nach einem der Ansprüche 1 bis 5, bei dem auf einen Träger
- zunächst in einem ersten Lithografieschritt ein erster Fotolack aufgebracht wird, in Form gewünschter Prägeelemente mit einer ersten Strukturgröße belichtet und entwickelt wird, um einen ersten Teilbereich mit den gewünschten Prägeelementen entsprechenden Strukturelementen mit einer ersten charakteristischen Strukturgröße zu erzeugen, und
- nachfolgend in einem zweiten Lithografieschritt ein zweiter Fotolack aufgebracht wird, in Form gewünschter Prägeelemente mit einer zweiten Strukturgröße belichtet und entwickelt wird, um einen zweiten Teilbereich mit den gewünschten Prägeelementen entsprechenden Strukturelementen mit einer zweiten charakteristischen Strukturgröße zu erzeugen, die sich um mindestens einen Faktor 1,5 von der ersten Strukturgröße unterscheidet.

7. Verfahren nach Anspruch 6, **dadurch gekennzeichnet, dass** im ersten Lithografieschritt als erster Fotolack ein E-Beam-Resist aufgebracht wird und die Belichtung mittels Elektronstrahl erfolgt, und im zweiten Lithografieschritt als zweiter Fotolack ein fotosensitver Resist aufgebracht wird, und die Belichtung durch elektromagnetische Strahlung, vorzugsweise durch Laserbestrahlung erfolgt.

8. Verfahren nach Anspruch 6 oder 7, **dadurch gekennzeichnet, dass** im ersten Lithografieschritt Strukturelemente in Form eines Subwellenlängengitters oder diffraktiven Gitters und/ oder im zweiten Lithografieschritt Strukturelemente in Form eines Mikrospiegelrasters oder Mikrolinsenrasters erzeugt werden.

9. Verfahren nach wenigstens einem der Ansprüche 6 bis 8, **dadurch gekennzeichnet, dass** im ersten Lithografieschritt zusätzlich Positionsmarken erzeugt werden, die im zweiten Lithografieschritt nach dem Aufbringen des zweiten Fotolacks und vor der Einbelichtung der Prägeelemente mit der zweiten Strukturgröße freigelegt werden.

10. Verfahren nach wenigstens einem der Ansprüche 6 bis 9, **dadurch gekennzeichnet, dass** der zweite Fotolack im zweiten Lithografieschritt auf den entwickelten ersten Fotolack des ersten Lithografieschritts aufgebracht wird, oder dass zwischen dem ersten und zweiten Lithografieschritt eine Hilfsabformung der im ersten Lithografieschritt erzeugten Strukturelemente erzeugt wird und der zweite Fotolack im zweiten Lithografieschritt auf eine Zwischenabformung aufgebracht wird, die durch die Hilfsabformung gebildet ist oder durch eine weitere Abformung aus der Hilfsabformung erzeugt wird.

11. Verfahren zur Herstellung einer Prägeplatte nach einem der Ansprüche 1 bis 5, bei dem
- ein Träger mit einer ersten Oberflächen-Reliefstruktur in Form gewünschter Prägeelemente mit einer ersten Strukturgröße bereitgestellt wird,
- in einem Lithografieschritt ein thermoplastischer Fotolack auf den Träger mit der ersten Reliefstruktur aufgebracht und in einem Heißprägeprozess auf der der ersten Reliefstruktur gegenüberliegenden Seite des Fotolacks mit einer zweiten Reliefstruktur in Form gewünschter Prägeelemente mit einer zweiten Strukturgröße versehen wird, wobei sich die zweite Strukturgröße um mindestens einen Faktor 1,5 von der ersten Strukturgröße unterscheidet, und
- der thermoplastische Fotolack lokal unterschiedlich belichtet und dann entwickelt wird, um in einem ersten Teilbereich die erste Reliefstruktur freizulegen und in einem zweiten Teilbereich die zweite Reliefstruktur des thermoplastischen Fotolacks zu erhalten.

12. Verfahren nach Anspruch 11, **dadurch gekennzeichnet, dass** in dem Belichtungs- und Entwicklungsschritt der thermoplastische Fotolack in einem dritten Teilbereich teilweise, aber nicht vollständig entfernt wird, um dort ein Plateau oder eine weitere Reliefstruktur zu erzeugen, welche vorzugsweise in Form gewünschter Prägeelemente mit einer dritten Strukturgröße versehen wird, die sich von der ersten und zweiten Strukturgröße jeweils um mindestens einen Faktor 1,5 unterscheidet.

13. Verfahren nach Anspruch 11 oder 12, **dadurch gekennzeichnet, dass** die Teilbereiche paarweise miteinander verflochten sind.

14. Verfahren zur Herstellung einer Prägeplatte nach einem der Ansprüche 1 bis 5, bei dem
- auf einen Träger ein Kombi-Resist aufgebracht wird, der sowohl für Elektronenstahlbelichtung als auch für Laserbelichtung empfindlich ist,
- der Kombi-Resist in einem Belichtungsschritt E) mit einem Elektronenstrahlschreiber in Form gewünschter Prägeelemente mit einer ersten Strukturgröße belichtet wird,
- der Kombi-Resist in einem Belichtungsschritt L) mit einem Laserschreiber in Form gewünschter Prägeelemente mit einer zweiten Strukturgröße belichtet wird, wobei sich die zweite Strukturgröße um mindestens einen Faktor 1,5 von der ersten Strukturgröße unterscheidet, und
- der in den Belichtungsschritten E) und L) belichtete Kombi-Resist entwickelt wird, um gleichzeitig einen ersten Teilbereich mit den gewünschten Prägeelementen entsprechenden Strukturelementen mit der ersten charakteristischen Strukturgröße und einen zweiten Teilbereich mit den gewünschten Prägeelementen entsprechenden Strukturelementen mit der zweiten charakteristischen Strukturgröße zu erzeugen.

15. Verfahren nach Anspruch 14, **dadurch gekennzeichnet, dass** der Belichtungsschritt E) vor dem Belichtungsschritt L) ausgeführt wird, und/ oder dass die Teilbereiche paarweise miteinander verflochten sind.

16. Verfahren nach Anspruch 14 oder 15, **dadurch gekennzeichnet, dass** vor dem Aufbringen des Kombi-Resists Positionsmarken in dem Träger erzeugt, insbesondere in den Träger geätzt werden, die nach dem Aufbringen des Kombi-Resists und vor den Belichtungsschritten E) und L) freigelegt werden.

17. Verfahren nach wenigstens einem der Ansprüche 6 bis 16, **dadurch gekennzeichnet, dass** die Prägeplatte aus dem mit Strukturelementen versehenen Träger durch galvanische Abformung oder in einem Nanoimprint-Verfahren erzeugt wird.

18. Sicherheitselement mit einem geprägten Gesamtmotiv aus zumindest drei Teilbereichen mit unterschiedlichem optischem Erscheinungsbild, wobei
- die Teilbereiche motivförmig ausgebildet und jeweils paarweise passergenau zueinander angeordnet sind, wobei die Teilbereiche paarweise direkt aneinander grenzen, und
- in jedem Teilbereich das Prägerelief aus einer Vielzahl von Prägeelementen mit einer charakteristischen Strukturgröße vorliegt, wobei sich die charakteristischen Strukturgrößen der Prägeelemente zweier Teilbereiche paarweise um mindestens einen Faktor 1,5 unterscheiden,
wobei einer der Teilbereiche als Prägeelemente ein Subwellenlängengitter enthält und die charakteristische Strukturgröße der Prägeelemente die Gitterperiode des Subwellenlängengitters ist, und/ oder einer der Teilbereiche als Prägeelemente ein diffraktives Gitter enthält und die charakteristische Strukturgröße der Prägeelemente die Gitterperiode des diffraktiven Gitters ist, und/ oder einer der Teilbereiche als Prägeelemente ein Mikrospiegelraster oder Mikrolinsenraster enthält und die charakteristische Strukturgröße der Prägeelemente die Rasterperiode der Mikrospiegel oder Mikrolinsen ist.

## Claims

1. An embossing plate (110) for embossing in an embossing substrate a desired motif (20) that includes at least three sub-regions (22,24,26) having different optical appearances,
- the embossing plate being furnished with an embossing relief (112) in the form of the inverted desired motif,
- the embossing relief including at least three sub-regions that, in each case, are arranged in perfect register with one another pairwise, the sub-regions bordering directly on one another pairwise,
- the embossing relief in each sub-region consisting of a plurality of embossing elements having a characteristic structure size, and the characteristic structure sizes of the embossing elements of two sub-regions differing, pairwise, by at least a factor of 1.5,
one of the sub-regions including, as embossing elements, a subwavelength grating, and the characteristic structure size of the embossing elements being the grating period of the subwavelength grating, and/or one of the sub-regions including, as embossing elements, a diffractive grating, and the characteristic structure size of the embossing elements being the grating period of the diffractive grating, and/ or one of the sub-regions including, as embossing elements, a micromirror grid or microlens grid, and the characteristic structure size of the embossing elements being the grid period of the micromirrors or microlenses.

2. The embossing plate according to claim 1, **characterized in that** the sub-regions are each formed in a motif form.

3. The embossing plate according to claim 1 or 2, **characterized in that** the sub-regions are interwoven with each other pairwise.

4. The embossing plate according to at least one of claims 1 to 3, **characterized in that** one of the difference factors is at least equal to 2, one of the difference factors is at least equal to 5 and one of the difference factors is at least equal to 10.

5. The embossing plate according to at least one of claims 1 to 4, **characterized in that** the embossing relief consists of exactly three sub-regions.

6. A method for manufacturing an embossing plate according to one of claims 1 to 5, in which, on a carrier,
- first, in a first lithography step, a first photoresist is applied, is exposed and developed in the form of desired embossing elements having a first structure size in order to produce a first sub-region having structure elements that correspond to the desired embossing elements and have a first characteristic structure size, and
- subsequently, in a second lithography step, a second photoresist is applied, is exposed and developed in the form of desired embossing elements having a second structure size in order to produce a second sub-region having structure elements that correspond to the desired embossing elements and have a second characteristic structure size that differs from the first structure size by at least a factor of 1.5.

7. The method according to claim 6, **characterized in that**, in the first lithography step, an e-beam resist is applied as the first photoresist, and the exposure occurs by means of electron beam, and in the second lithography step, a photosensitive resist is applied as the second photoresist, and the exposure occurs through electromagnetic radiation, preferably through laser irradiation.

8. The method according to claim 6 or 7, **characterized in that,** in the first lithography step, structure elements in the form of a subwavelength grating or diffractive grating are produced and/ or, in the second lithography step, structure elements in the form of a micromirror grid or a microlens grid are produced.

9. The method according to at least one of claims 6 to 8, **characterized in that,** in the first lithography step, in addition, position marks are produced that are uncovered in the second lithography step, after the application of the second photoresist and before the overlaying of the embossing elements having the second structure size.

10. The method according to at least one of claims 6 to 9, **characterized in that,** in the second lithography step, the second photoresist is applied to the developed first photoresist of the first lithography step, or **in that,** between the first and second lithography step, an auxiliary molding of the structure elements produced in the first lithography step is produced, and in the second lithography step, the second photoresist is applied to an intermediate molding that is formed by the auxiliary molding or is produced from the auxiliary molding by a further molding.

11. A method for manufacturing an embossing plate according to one of claims 1 to 5, in which
- a carrier having a first surface relief structure in the form of desired embossing elements having a first structure size is provided,
- in a lithography step, a thermoplastic photoresist is applied to the carrier having the first relief structure and, in a hot embossing process, is furnished on the side of the photoresist opposite the first relief structure with a second relief structure in the form of desired embossing elements having a second structure size, the second structure size differing from the first structure size by at least a factor of 1.5, and
- the thermoplastic photoresist is exposed and then developed locally differently in order to uncover the first relief structure in a first sub-region and to preserve the second relief structure of the thermoplastic photoresist in a second sub-region.

12. The method according to claim 11, **characterized in that,** in the exposure and development step, the thermoplastic photoresist is partially but not completely removed in a third sub-region to produce there a plateau or a further relief structure that is preferably produced in the form of desired embossing elements having a third structure size that differs from the first and second structure size by at least a factor of 1.5 in each case.

13. The method according to claim 11 or 12, **characterized in that** the sub-regions are interwoven with each other pairwise.

14. A method for manufacturing an embossing plate according to one of claims 1 to 5, in which
- a combination resist that is sensitive to both electron beam exposure and laser exposure is applied to a carrier,
- in an exposure step E), with an electron beam writer, the combination resist is exposed in the form of desired embossing elements having a first structure size
- in an exposure step L), with a laser writer, the combination resist is exposed in the form of desired embossing elements having a second structure size, the second structure size differing from the first structure size by at least a factor of 1.5, and
- the combination resist exposed in the exposure steps E) and L) is developed in order to simultaneously produce a first sub-region having structure elements that correspond to the desired embossing elements and have the first characteristic structure size, and a second sub-region having structure elements that correspond to the desired embossing elements and have the second characteristic structure size.

15. The method according to claim 14, **characterized in that** the exposure step E) is executed before the exposure step L), and/or **in that** the sub-regions are interwoven with each other pairwise.

16. The method according to claim 14 or 15, **characterized in that,** before the application of the combination resist, there are produced in the carrier, especially etched in the carrier, position marks that are uncovered after the application of the combination resist and before the exposure steps E) and L).

17. The method according to at least one of claims 6 to 16, **characterized in that** the embossing plate composed of the carrier furnished with structure elements is produced by galvanic molding or in a nanoimprint method.

18. A security element having an embossed complete motif composed of at least three sub-regions having different optical appearances,
- the sub-regions being formed in a motif form and, in each case, being arranged in perfect register with one another pairwise, the sub-regions bordering directly on one another pairwise, and
- in each sub-region, the embossing relief being present composed of a plurality of embossing elements having a characteristic structure size, the characteristic structure sizes of the embossing elements of two sub-regions differing, pairwise, by at least a factor of 1.5,
one of the sub-regions including, as embossing elements, a subwavelength grating, and the characteristic structure size of the embossing elements being the grating period of the subwavelength grating, and/or one of the sub-regions including, as embossing elements, a diffractive grating, and the characteristic structure size of the embossing elements being the grating period of the diffractive grating, and/ or one of the sub-regions including, as embossing elements, a micromirror grid or microlens grid, and the characteristic structure size of the embossing elements being the grid period of the micromirrors or microlenses.

## Revendications

1. Plaque à gaufrer (110) pour gaufrer un motif souhaité (20), qui contient au moins trois zones partielles (22,24,26) avec des aspects optiques différents dans un substrat de gaufrage, dans lequel
- la plaque à gaufrer est pourvue d'un relief de gaufrage (112) en forme de motif souhaité,
- le relief de gaufrage contient au moins trois zones partielles disposées respectivement par paires les unes après les autres, dans lequel les zones partielles se jouxtent directement par paires,
- dans lequel le relief de gaufrage dans chaque zone partielle est constitué d'une pluralité d'éléments de gaufrage avec une taille structurelle caractéristique, et les tailles structurelles caractéristiques des éléments de gaufrage de deux zones partielles différent par paires d'au moins un facteur de 1,5,
dans lequel une des zones partielles contient un réseau de sous-longueur d'onde comme éléments de gaufrage et la taille structurelle caractéristique des éléments de gaufrage est la période de réseau du réseau de sous-longueur d'onde, et/ ou une des zones partielles contient un réseau de diffraction en tant qu'éléments de gaufrage et la taille structurelle caractéristique des éléments de gaufrage la période de réseau du réseau de diffraction, et/ ou une des zones partielles contient une grille de micromiroirs ou une grille de microlentilles en tant qu'éléments de gaufrage et la taille structurelle caractéristique des éléments de gaufrage est la période de grille des micromiroirs ou des microlentilles.

2. Plaque à gaufrer selon la revendication 1, **caractérisée en ce que** les zones partielles sont conçues respectivement sous la forme d'un motif.

3. Plaque à gaufrer selon la revendication 1 ou 2, **caractérisée en ce que** les zones partielles sont entrelacées par paires.

4. Plaque à gaufrer selon au moins une des revendications 1 à 3, **caractérisée en ce que** un des facteurs de différence est au moins égal à 2, l'un des facteurs de différence est au moins égal à 5 et un des facteurs de différence est à moins égal à 10.

5. Plaque à gaufrer selon au moins une des revendications 1 à 4, **caractérisée en ce que** le relief de gaufrage se compose d'exactement trois zones partielles.

6. Procédé de fabrication d'une plaque à gaufrer selon une des revendications 1 à 5, dans lequel sur un support
- une première résine photosensible est appliquée dans une première étape de lithographie, est exposée et développée sous la forme d'éléments de gaufrage souhaités avec une première taille structurelle, afin de produire une première zone partielle avec des éléments structurels correspondant aux éléments de gaufrage souhaités avec une première taille structurelle caractéristique, et
- ensuite, dans une deuxième étape de lithographie, une deuxième résine photosensible est appliquée, est exposée et développée sous la forme d'éléments de gaufrage souhaités, afin de produire une deuxième zone partielle avec des éléments structurels correspondant aux éléments de gaufrage souhaités avec une deuxième taille structurelle caractéristique, qui diffère d'au moins un facteur 1,5 de la première taille structurelle.

7. Procédé selon la revendication 6, **caractérisé en ce que** dans la première étape de lithographie, une réserve pour faisceau d'électrons est appliquée en tant que première résine photosensible et l'exposition est effectuée au moyen d'un faisceau d'électrons, et dans la deuxième étape de lithographie, une réserve photosensible est appliquée en tant que deuxième résine photosensible, et l'exposition est réalisée par rayonnement électromagnétique, de préférence par irradiation laser.

8. Procédé selon la revendication 6 ou 7, **caractérisé en ce que** des éléments structurels sous la forme d'un réseau de sous-longueur d'onde ou d'un réseau diffractif et/ ou dans la deuxième étape de lithographie des éléments structurels sous la forme d'une grille de micromiroirs ou de microlentilles sont produits dans la première étape de lithographie.

9. Procédé selon au moins une des revendications 6 à 8, **caractérisé en ce que** dans la première étape de lithographie, des marques de position supplémentaires sont générées dans la deuxième étape de lithographie, qui sont exposés avec la deuxième taille structurelle après l'application de la deuxième résine photosensible et avant l'exposition des éléments de gaufrage.

10. Procédé selon au moins une des revendications 6 à 9, **caractérisé en ce que** la deuxième résine photosensible est appliquée dans la deuxième étape de lithographie sur la première résine photosensible développée de la première étape de lithographie, ou qu'entre la première et la deuxième étape de lithographie, une empreinte auxiliaire des éléments structurels produits dans la première étape de lithographie est produite et la deuxième résine photosensible est appliquée dans la deuxième étape de lithographie sur une empreinte intermédiaire, qui est formée par l'empreinte auxiliaire ou est produite par une autre empreinte à partir de l'empreinte auxiliaire.

11. Procédé de fabrication d'une plaque à gaufrer selon une quelconque des revendications 1 à 5, dans lequel
- un support avec une première structure en relief de surface sous la forme d'éléments de gaufrage souhaités avec une première taille structurelle est prévu,
- dans une étape de lithographie, une résine photosensible thermoplastique est appliquée sur le support avec la première structure en relief et dans un processus de gaufrage à chaud est pourvu sur le côté opposé à la première structure en relief de la résine photosensible d'une deuxième structure en relief sous la forme d'éléments de gaufrage souhaités avec une deuxième taille structurelle, dans lequel la deuxième taille structurelle diffère de la première taille structurelle d'au moins un facteur de 1,5, et
- la résine photosensible thermoplastique est exposée différemment localement et est ensuite développée, afin d'exposer la première structure en relief dans une première zone partielle et d'obtenir la deuxième structure en relief de la résine thermoplastique dans une deuxième zone partielle.

12. Procédé selon la revendication 11, **caractérisé en ce que** dans l'étape d'exposition et de développement, la résine photosensible thermoplastique est partiellement mais non totalement retirée dans une troisième zone partielle afin d'y réaliser un plateau ou une autre structure en relief, qui est réalisée de préférence sous la forme d'éléments de gaufrage souhaités avec une troisième taille structurelle, qui diffère de la première et de la deuxième taille structurelle d'au moins un facteur de 1,5.

13. Procédé selon la revendication 11 ou 12, **caractérisé en ce que** les zones partielles sont entrelacées par paires.

14. Procédé de réalisation d'une plaque à gaufrer selon une quelconque des revendications 1 à 5, dans lequel
- sur un support, une réserve combinée est appliquée, qui est sensible à la fois à l'exposition au faisceau d'électrons et à l'exposition au laser,
- la réserve combinée est exposée dans une étape d'exposition E) avec un graveur à faisceau d'électrons sous la forme d'éléments de gaufrage souhaités avec une première taille structurelle,
- la réserve combinée dans une étape d'exposition L) est exposée avec une deuxième taille structurelle avec un graveur laser sous la forme d'éléments de gaufrage souhaités, dans lequel la deuxième taille structurelle diffère d'au moins un facteur de 1,5 de la première taille structurelle, et
- la réserve combinée exposée dans les étapes d'exposition E) et L) est développée afin de créer simultanément une première zone partielle avec les éléments structurels correspondant aux éléments de gaufrage souhaités avec la première taille structurelle caractéristique et une deuxième zone partielle avec les éléments structurels correspondant aux éléments de gaufrage souhaités avec la deuxième taille structurelle caractéristique.

15. Procédé selon la revendication 14, **caractérisé en ce que** l'étape d'exposition E) est effectuée avant l'étape d'exposition L) et/ ou que les zones partielles sont entrelacées par paires.

16. Procédé selon la revendication 14 ou 15, **caractérisé en ce qu'**avant l'application de la réserve combinée, des marques de position sont générées dans le support, notamment gravées dans le support, qui sont exposée après l'application de la résine de combinaison et avant les étapes d'exposition E) et L).

17. Procédé selon au moins une des revendications 6 à 16, **caractérisé en ce que** la plaque à gaufrer est réalisée à partir du support pourvu d'éléments structurels par moulage galvanique ou dans un procédé de nanoimpression.

18. Élément de sécurité comportant un motif global en relief d'au moins trois zones partielles avec des aspects optiques différents, dans lequel
- les zones partielles sont conçues sous la forme d'un motif et sont agencées par paires en alignement les unes avec les autres, dans lequel les zones partielles se jouxtent directement par paires, et
- dans chaque zone partielle, le relief de gaufrage est constitué d'un grand nombre d'éléments de gaufrage avec une taille structurelle caractéristique, dans lequel les tailles structurelles caractéristiques des éléments de gaufrage de deux zones partielles différent par paires d'au moins un facteur de 1,5,
dans lequel une des zones partielles contient un réseau de sous-longueur d'onde comme éléments de gaufrage et la taille structurelle caractéristique des éléments de gaufrage est la période de réseau du réseau de sous-longueur d'onde, et/ ou une des zones partielles contient un réseau de diffraction en tant qu'éléments de gaufrage et la taille structurelle caractéristique des éléments de gaufrage est la période de réseau du réseau de diffraction, et/ ou une des zones partielles contient une grille de micromiroirs ou une grille de microlentilles en tant qu'éléments de gaufrage et la taille structurelle caractéristique des éléments de gaufrage est la période de grille des micromiroirs ou des microlentilles.
